# EUROPEAN PATENT SPECIFICATION

(11) **EP 3 118 412 B1**
(45) Date of publication and mention of the grant of the patent: **14.10.2020**
(21) Application number: 16178063.0
(22) Date of filing: 05.07.2016
(51) Int. Cl.: F01D 5/14

(54) **METHOD FOR GENERATING AN AIRFOIL INCLUDING AN AERODYNAMICALLY-SHAPED FILLET AND AIRFOILS INCLUDING THE AERODYNAMICALLY-SHAPED FILLET**
VERFAHREN ZUR ERZEUGUNG EINER SCHAUFEL MIT EINER AERODYNAMISCH GEFORMTEN AUSRUNDUNG UND SCHAUFEL MIT DER AERODYNAMISCH GEFORMTEN AUSRUNDUNG
PROCÉDÉ DE GÉNÉRATION D'UN PROFIL AÉRODYNAMIQUE COMPRENANT UN FILET DE FORME AÉRODYNAMIQUE ET LESDITS PROFILS AÉRODYNAMIQUES

(30) Priority: 06.07.2015 US 201514792097
(43) Date of publication of application: 18.01.2017
(73) Proprietor: United Technologies Corporation, Farmington, CT 06032 (US)
(72) Inventor: SZYMANSKI, Stanley J., Portland, CT 06480-1611 (US)
(74) Representative: Dehns

(56) References cited:
- EP-A1- 1 669 544
- EP-A1- 2 738 352

## Description

### FIELD

The present disclosure relates to gas turbine engines, and, more specifically, to methods for generating an airfoil including an aerodynamically-shaped fillet and airfoils including the aerodynamically-shaped fillet.

### BACKGROUND

A gas turbine engine has a compressor section, a combustor section and a turbine section. In operation, the compressor section can induct air and compress it. The compressed air can enter the combustor section where it can be mixed with fuel. The air-fuel mixture is ignited, thereby forming a high temperature working gas. The high temperature working gas is routed to the turbine section.

The compressor section includes at least one compressor including one or more compressor stages with airfoils spaced in a circumferential direction around a longitudinal centerline axis. Each compressor stage has a number of annular airfoil rows attached usually in pairs, one rotating and one stationary. The pair of rotating and stationary airfoils is called a stage. The rotating airfoils, also known as blades or rotors, accelerate the gas. The stationary airfoils, also known as stators or vanes, convert the increased rotational kinetic energy into static pressure through diffusion and redirect the flow direction of the gas, preparing it for the rotating airfoils of the next stage.

The airfoils are aerodynamically shaped for optimum aerodynamic efficiency. A transition region between the airfoil and a platform defining a flowpath surface, or between the airfoil and a revolved or 3D-shaped flowpath surface of an Integrally Bladed Rotor, is typically configured as a fillet. In a rolling ball method for generating the fillet (a "rolling-ball fillet"), a virtual ball with a radius equal to the fillet radius is placed in contact with the two surfaces and then rolled along the joint, keeping in contact with both surfaces. However, the fillet surface generated by the rolling-ball is uniformly determined (defined simply by the airfoil tangency curve and the flowpath tangency curve). While a rolling-ball fillet on a normal airfoil has a constant radius R on both sides of the airfoil, the rolling-ball fillet on an airfoil that is not normal to the flowpath surface maintains the same radius on each side of the airfoil, but different arc lengths of the radius (due to the different contact points on the rolling ball), adding different amounts of material to the fillet on the sides of the airfoil. In addition, the rolling-ball method ignores the airfoil and flowpath surface inflections (e.g., camber and twist changes, leading and trailing edge angle changes, etc.) within the transition region. The rolling ball method has further modeling limitations (i.e., self-intersecting surfaces) most notably around a trailing edge of an airfoil when the airfoil is canted back (i.e., leaned aft) and the trailing edge intersects the flowpath surface at an acute angle, when viewed in an "engine left" direction (e.g., from the perspective of a pilot sitting in a cockpit).

A prior art gas turbine engine rotor blade having an aerodynamic fillet between an airfoil and a tip shroud is disclosed in EP 2,738,352.

### SUMMARY

From one aspect, the present invention provides a method for generating a computer model of an airfoil including an aerodynamically-shaped fillet in accordance with claim 1.

Other features of embodiments are recited in the dependent claims.

### BRIEF DESCRIPTION OF THE DRAWINGS

The subject matter of the present disclosure is particularly pointed out and distinctly claimed in the concluding portion of the specification. A more complete understanding of the present disclosure, however, may best be obtained by referring to the detailed description and claims when considered in connection with the figures, wherein like numerals denote like elements.

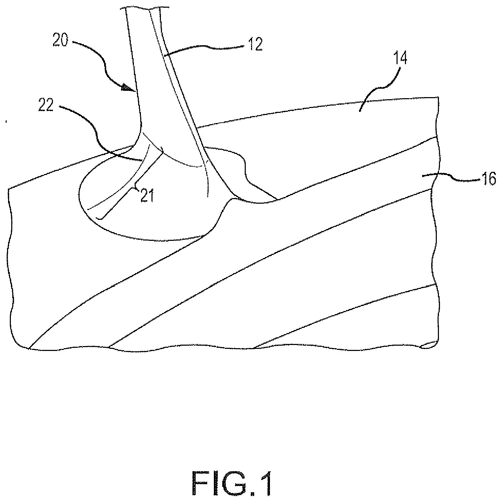

FIG. 1 depicts an airfoil including an exemplary aerodynamically-shaped fillet for transitioning to a revolved 3D-shaped flowpath surface of an integrally bladed rotor ("IBR") of a compressor, the airfoil generated by the methods according to various embodiments as described in the present disclosure;

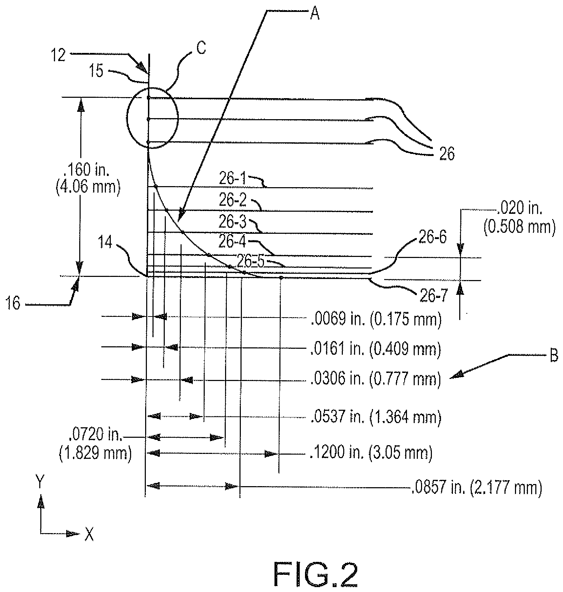

FIG. 2 is an exemplary 2D image of a portion of an airfoil with an airfoil surface line and including a transition region interconnected to a flowpath surface line of an end wall and including a plurality of flowpath offset lines, the 2D image used to generate the airfoil including the aerodynamically-shaped fillet (such as shown in FIG. 1) by the methods according to various embodiments;

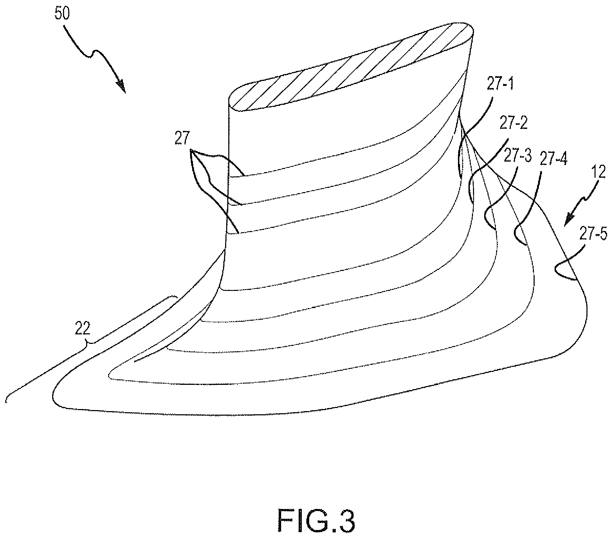

FIG. 3 is a perspective view of an exemplary computer model of an airfoil including an aerodynamically-shaped fillet generated from the plurality of 3D fillet streamline curves, the computer model used to generate the airfoil including the aerodynamically-shaped fillet (such as shown in FIG. 1) by the methods according to various embodiments;

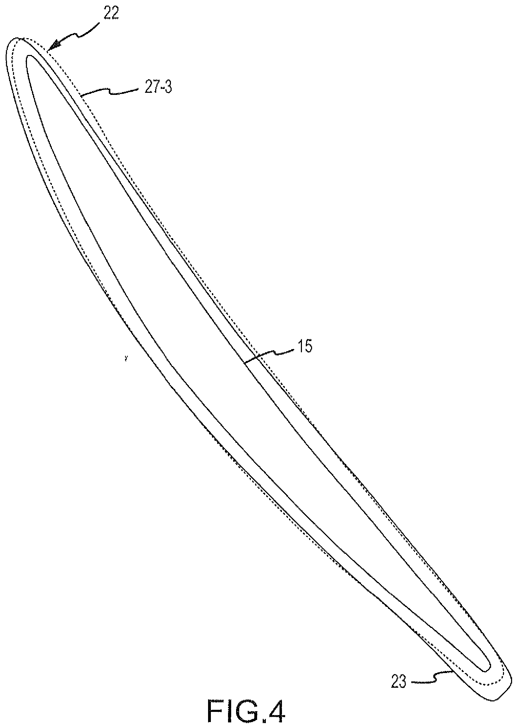

FIG. 4 illustrates a section cut along a 3D fillet streamline curve (dotted lines) taken from the middle of the aerodynamically-shaped fillet of FIG. 3 (the aerodynamically-shaped fillet partially shown in FIG. 3) according to various embodiments, as compared against illustrations of a section cut along a conventional fillet streamline curve taken through the middle of a conventional fillet, and of an original airfoil; and

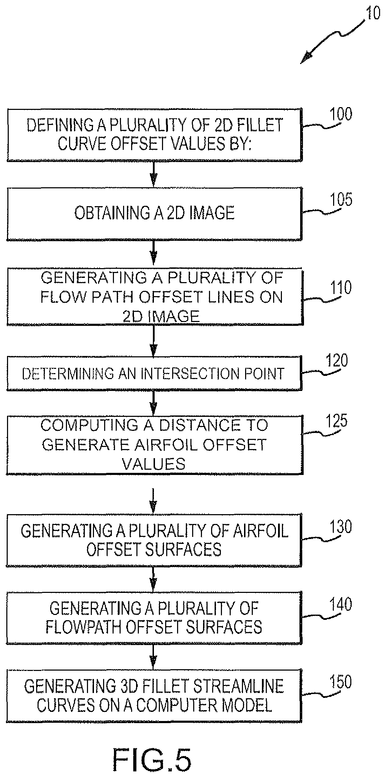

FIG. 5 depicts a flowchart illustrating exemplary methods for generating an airfoil including an aerodynamically-shaped fillet according to various embodiments.

### DETAILED DESCRIPTION

The detailed description of exemplary embodiments herein makes reference to the accompanying drawings, which show exemplary embodiments by way of illustration. While these exemplary embodiments are described in sufficient detail to enable those skilled in the art to practice the exemplary embodiments of the disclosure, it should be understood that other embodiments may be realized and that logical changes and adaptations in design and construction may be made in accordance with this disclosure and the teachings herein. Thus, the detailed description herein is presented for purposes of illustration only and not limitation. The steps recited in any of the method or process descriptions may be executed in any order and are not necessarily limited to the order presented.

Furthermore, any reference to singular includes plural embodiments, and any reference to more than one component or step may include a singular embodiment or step. Also, any reference to attached, fixed, connected or the like may include permanent, removable, temporary, partial, full and/or any other possible attachment option. Additionally, any reference to without contact (or similar phrases) may also include reduced contact or minimal contact. Surface shading lines may be used throughout the figures to denote different parts but not necessarily to denote the same or different materials.

As used herein, "aft" refers to the direction associated with the tail (e.g., the back end) of an aircraft, or generally, to the direction of exhaust of the gas turbine. As used herein, "forward" refers to the direction associated with the nose (e.g., the front end) of an aircraft, or generally, to the direction of flight or motion.

As used herein, "distal" refers to the direction radially outward, or generally, away from the axis of rotation of a turbine engine. As used herein, "proximal" refers to a direction radially inward, or generally, towards the axis of rotation of a turbine engine.

Various embodiments are directed to methods for generating an airfoil including an aerodynamically-shaped fillet and airfoils including the aerodynamically-shaped fillet. The aerodynamically-shaped fillet replicates the shape of the aerodynamic shape of the airfoil, taking in account changes in camber and twist, leading edge angle and shape, trailing edge angle and shape, etc. (hereinafter "an inflection"), thereby maintaining the aerodynamic efficiency of the aerodynamically-shaped airfoil (i.e., the fillet is no longer an aerodynamic debit). While various embodiments are described with reference to an airfoil (rotating and stationary) (e.g., a compressor blade or compressor vane) in a compressor, various embodiments may also impart an aerodynamic shape to a transition feature (e.g., a fillet) of a fan blade, or other gas turbine engine component. As used herein, the term "aerodynamic shape" is generally known to one skilled in the art and includes a shape imparted to the airfoil to increase aerodynamic efficiency of the gas turbine engine component. For example, the aerodynamic shape of an airfoil (and an aerodynamically-shaped fillet thereof) is imparted by at least one inflection thereof.

Referring to FIG. 1, according to various embodiments, an airfoil 12 including an exemplary aerodynamically-shaped fillet 22 is depicted. The aerodynamically-shaped fillet 22 is configured to interconnect the airfoil with a flowpath surface 14 of an end wall 16 of a gas turbine engine component 20. Gas turbine engine components include, for example, a compressor blade, a compressor vane, a turbine blade, a turbine vane, a fan blade, etc. When the component 20 is a compressor blade, the end wall 16 can be a platform or revolved surface (such as shown in FIG. 1). When the component 20 is a compressor vane, the end wall 16 can be a shroud. The airfoil 12 can transition to the end wall 16 in a transition region 21 defined by the aerodynamically-shaped fillet 22.

Referring now to FIG. 5, a method 10 for generating the airfoil including an aerodynamically-shaped fillet (such as shown in FIG. 1) according to various embodiments is disclosed. The method 10 for generating the airfoil including the aerodynamically-shaped fillet may be executed on a computing device comprising a processor, a tangible, non-transitory memory configured to communicate with the processor, the tangible, non-transitory memory having instructions stored thereon that, in response to execution by the processor, cause the processor to perform operations described herein. A conventional CAD system may be used to design and model the airfoil including the aerodynamically-shaped fillet.

Referring now to FIG. 2 and still referring to FIG. 5, according to various embodiments, the method 10 for generating the airfoil including an aerodynamically-shaped fillet (such as shown in FIG. 1) begins by defining a plurality of 2D fillet curve offset values (step 100). The step of defining the plurality of 2D fillet curve offset values begins by obtaining a 2D image of the airfoil 12 (or at least the transition region thereof) transitioning to a flowpath surface line 14 of end wall 16 with a 2D fillet curve A (step 105). FIG. 2 depicts a portion of an exemplary airfoil with an airfoil surface line 15 normal to the flowpath surface line 14 and having a transition region defined by the 2D fillet curve A of a 2D rolling-ball fillet between the airfoil surface line and the end wall 16.

Still referring to FIGS. 2 and 5, according to various embodiments, the step of defining the plurality of 2D fillet curve offset values continues by generating a plurality of flowpath offset lines 26 and 26-1 through 26-7 on the 2D image (step 110). The plurality of flowpath offset lines are positioned at pre-determined flowpath offset values (i.e., radial spacing) (e.g., .020 inches (0.508 mm) in FIG. 2 comprises an exemplary pre-determined flowpath offset value). The flowpath offset values are predetermined to control the smoothness and fidelity of the final contour of the aerodynamically-shaped fillet from the 2D fillet curve contour. The flowpath offset lines 26 and 26-1 through 26-7 are radially spaced and are configured to represent 3D fillet streamline curves around the airfoil to be generated, the streamlines representing the flow of air along the airfoil and fillet surface as known in the art. Flowpath offset lines 26 and 26-1 through 26-7 may be equally spaced apart and/or unequally spaced apart. While eleven flowpath offset lines are depicted in FIG. 2, it is to be understood that any number of flowpath offset lines may be generated. Each flowpath offset line in the transition region intersects the 2D fillet curve at an intersection point. Each flowpath offset line graphically represents a linear flowpath offset surface from an inner flowpath 14 to an outer flowpath (toward an airfoil tip).

Still referring to FIGS. 2 and 5, according to various embodiments, the step of defining the plurality of 2D fillet curve offset values continues by determining an intersection point between the 2D fillet curve and each flowpath offset line (step 120) and computing a distance between the airfoil surface line 15 and each intersection point to generate a plurality of airfoil offset values (step 125).

The airfoil surface offsets are defined by the plurality of airfoil offset values (exemplary airfoil offset values are identified in FIG. 2 with the letter "B") determined in step 125. Each airfoil offset value corresponds to a change in airfoil thickness represented by each 3D fillet streamline curve in the transition region as hereinafter described. Each airfoil offset value (B in FIG. 2) is determined by computing the distance between the airfoil surface line and the intersection point in the transition region to generate a plurality of airfoil offset values. The 2D fillet curve offset values define the 3D fillet streamline curves that are incorporated into the computer model to define the aerodynamically-shaped fillet of the airfoil as hereinafter described. The 3D fillet streamline curves are produced from the 2D fillet curve offset values.

Thus, each intersection point includes dual offsets, the airfoil offset value and the flowpath offset value. Flowpath offset lines 26 above the 2D fillet curve are at zero airfoil offset value (identified in encircled region "C" in FIG. 2). The most radially inward of the flowpath offset lines 26 represents the tangency of the aerodynamically-shaped fillet on the flowpath. The intersection point for flowpath offset line 26-1 includes a very small airfoil offset value (e.g., .0069 inches (in.) (0.175 millimeters (mm)) in FIG. 2) but a relatively large flowpath offset value. The intersection point for flowpath offset line 26-2 includes a slightly larger airfoil offset value (e.g., .0161 inches (0.409 millimeters) in FIG. 2) and a slightly smaller flowpath offset value. The intersection point for flowpath offset line 26-7 has the largest airfoil offset value (typically the size of the 2D fillet curve radius) (e.g., .1200 inches (3.05 mm) in FIG. 2) and a zero flowpath offset value. Flowpath offset line 26-7 actually represents the flowpath surface and locates the fillet tangency on the flowpath surface. This lower edge may be radially above or below the flowpath surface and would be blended (patched) to the flowpath surface on the computer model of the airfoil per known CAD methods, as hereinafter described. While exemplary airfoil (surface) offset values and exemplary flowpath offset values as graphically represented by lines are provided in FIG. 2, it is to be understood that airfoil offset values and flowpath offset values may be changed to model any airfoil including an aerodynamically-shaped fillet.

Referring now to FIG. 3 and still to FIG. 5, according to various embodiments, the method 10 for generating the airfoil including the aerodynamically-shaped fillet continues by generating a plurality of airfoil offset surfaces according to each airfoil offset value on the computer model of the airfoil configured to include the aerodynamically-shaped fillet (step 130) and generating a plurality of flowpath offset surfaces according to each flowpath offset value on the computer model (step 140). Steps 130 and 140 may be performed in any order or simultaneously.

Still referring to FIGS. 3 and 5, according to various embodiments, the method 10 for generating the airfoil including the aerodynamically-shaped fillet continues by generating the plurality of 3D fillet streamline curves (27 and 27-1 through 27-5) by intersecting each airfoil offset surface with the corresponding flowpath offset surface on the computer model of the airfoil configured to include the aerodynamically-shaped fillet (such as depicted in FIG. 3) (step 150). The computer model used in steps 130, 140, and 150 may be the same or a different computer model. A computer model of an airfoil including the aerodynamically-shaped fillet will be generated from steps 130, 140, and 150. The airfoil including the aerodynamically-shaped fillet (such as depicted in FIG. 1) may be fabricated from the computer model.

As noted previously, the 2D fillet curve offset values define the 3D fillet streamline curves that are generated on the computer model to define the aerodynamically-shaped fillet of the airfoil. The 3D fillet streamline curves are produced from the 2D fillet curve offset values. 3D fillet streamline curves "replace" the (original) airfoil surface definition at the corresponding streamlines of the computer model, but do not change the shape of the airfoil above the transition region (i.e., above the aerodynamically-shaped fillet). 3D fillet streamline curves above the transition region are on the airfoil surface (zero airfoil offset) and may be used to stabilize radial stringers used for modeling as known to one skilled in the art. The 3D fillet streamline curve for each intersection point in the transition region is generated on the computer model 50 to effectively "replace" the (original) airfoil surface 15 definition at the corresponding streamline curve within the transition region of the computer model to define the aerodynamically-shaped fillet. The 2D fillet curve offset values define the 3D fillet streamline curves that describe the aerodynamically-shaped fillet, the 3D fillet streamline curves "re-assembled" in the computer model 50 of the airfoil to model the aerodynamically-shaped fillet of the airfoil. Material is added to the computer model of the airfoil at each offset curve with airfoil material in an amount equal to the airfoil offset value. The resultant aerodynamically-shaped fillet may comprise a compound fillet shape, a variable fillet shape, etc., instead of the conventional rolling ball fillet. The thickness of the aerodynamically-shaped fillet may be substantially equal on the concave and convex sides as well as on the leading and trailing edges forming a "constant offset". If aerodynamically beneficial, the thickness of the aerodynamically-shaped fillet at the airfoil leading edge may additionally be modified. For example, the sharpness of the aerodynamically-shaped fillet at the airfoil leading edge may be increased for a specific leading edge radius that could not be generated using the conventional rolling ball method. Any streamline curve (cut) of the aerodynamically-shaped fillet is a direct offset shape of the airfoil in the transition region that is aerodynamically-shaped. Therefore, the aerodynamic shape is maintained throughout the airfoil, including in the transition region defined by the aerodynamically-shaped fillet. FIG. 4 (plan view) depicts an exemplary section cut along a streamline curve (e.g., 27-3) taken from the middle of the aerodynamically-shaped fillet 22 of the computer model 50 of FIG. 3 (dotted lines), as compared against illustrations of a conventional fillet streamline 23 taken from the middle of a conventional fillet (i.e., a non-aerodynamically-shaped fillet) and of a conventional airfoil 15. Therefore, the aerodynamically-shaped fillet no longer represents an aerodynamic debit. The aerodynamically-shaped fillet is effectively shaped to meet the laminar flow on the airfoil surface, i.e., is "pushed out" to the offset curves. Moreover, by including the aerodynamically-shaped fillet in the computer model of the airfoil, a separate fillet modeling step may be eliminated. The computer model of the airfoil including the aerodynamically-shaped fillet may thereafter be used to fabricate the airfoil including the aerodynamically-shaped fillet, such as illustrated in FIG. 1. As noted previously, the airfoil may be attached to a platform of the gas turbine engine component using attachment methods well known in the art or made part of an Integrally Bladed Rotor.

While methods have been described for generating an airfoil including an aerodynamically-shaped fillet of compressor blades and compressor vanes, it is to be understood that according to various embodiments, the same methods may be use to impart an aerodynamic shape to transition features other than fillets for airfoils. For example, fillets and other transition features for turbine blades, turbine vanes, fan blades, or the like may be aerodynamically shaped in the same manner.

Benefits and other advantages have been described herein with regard to specific embodiments. Furthermore, the connecting lines shown in the various figures contained herein are intended to represent exemplary functional relationships and/or physical couplings between the various elements. It should be noted that many alternative or additional functional relationships or physical connections may be present in a practical system. However, the benefits, advantages, and any elements that may cause any benefit or advantage to occur or become more pronounced are not to be construed as critical, required, or essential features or elements of the disclosure. The scope of the disclosure is accordingly to be limited by nothing other than the appended claims, in which reference to an element in the singular is not intended to mean "one and only one" unless explicitly so stated, but rather "one or more." Moreover, where a phrase similar to "at least one of A, B, or C" is used in the claims, it is intended that the phrase be interpreted to mean that A alone may be present in an embodiment, B alone may be present in an embodiment, C alone may be present in an embodiment, or that any combination of the elements A, B and C may be present in a single embodiment; for example, A and B, A and C, B and C, or A and B and C.

Systems, methods and apparatus are provided herein. In the detailed description herein, references to "various embodiments", "one embodiment", "an embodiment", "an example embodiment", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. After reading the description, it will be apparent to one skilled in the relevant art(s) how to implement the disclosure in alternative embodiments.

## Claims

1. A method for generating a computer model of an airfoil (12) including an aerodynamically-shaped fillet (22), the method comprising:
inputting a 2D image of an airfoil (12) having an airfoil surface line (15) and including a transition region (21) interconnecting the airfoil surface line (15) to a flowpath surface line (14) with a 2D fillet curve (A);
generating a plurality of flowpath offset lines (26, 26-1...26-5) on the 2D image at pre-determined flowpath offset values, each flowpath offset line (26, 26-1...26-5) of the plurality of flowpath offset lines (26, 26-1... 26-5) in the transition region (21) graphically representing a flowpath offset surface of a plurality of flowpath offset surfaces;
determining an intersection point between the 2D fillet curve (A) and each flowpath offset line (26, 26-1...26-5);
computing a distance between the airfoil surface line (15) and each intersection point to generate a plurality of airfoil offset values (B);
generating a plurality of airfoil offset surfaces on the computer model of the airfoil being generated according to each airfoil offset value (B) of the plurality of airfoil offset values (B);
generating the plurality of flowpath offset surfaces on the computer model of the airfoil being generated according to each flowpath offset value; and
generating a plurality of 3D fillet streamline curves (27, 27-1...27-5) to define the aerodynamically-shaped fillet (22) on the computer model of the airfoil (12) being generated, each 3D fillet streamline curve (27, 27-1...27-5) comprising an intersection between an airfoil offset surface of the plurality of airfoil offset surfaces and a flowpath offset surface of the plurality of flowpath offset surfaces, wherein generating the plurality of 3D fillet streamline curves (27, 27-1...27-5) comprises replicating at least one inflection from the airfoil (12) into the aerodynamically-shaped fillet (22), wherein the at least one inflection comprises a change in camber, a change in twist, a leading edge shape or angle, a trailing edge shape or angle, or combinations thereof;
outputting the computer model of the airfoil (12) including the aerodynamically-shaped fillet (22).

2. The method of claim 1, wherein the airfoil (12) has a leading edge and a trailing edge, and opposing convex and concave sides, and generating a plurality of 3D fillet streamline curves (27, 27-1...27-5) comprises generating each 3D streamline curve (27, 27-1...27-5) of the plurality of 3D fillet streamline curves (27, 27-1...27-5) around the transition region (21) of the airfoil (12) to extend around the leading edge, the trailing edge, and the concave and convex sides of the airfoil (12), with the airfoil offset along each 3D fillet streamline curve (27, 27-1...27-5) being of substantially equal thickness such that the thickness of the aerodynamically-shaped fillet (22) at the leading edge, the trailing edge, and the concave and convex sides of the airfoil (12) is of substantially equal thickness.

## Patentansprüche

1. Verfahren zum Erzeugen eines Computermodells eines Schaufelblatts (12), das eine aerodynamisch geformte Ausrundung (22) beinhaltet, wobei das Verfahren Folgendes umfasst:
Eingeben einer 2D-Abbildung eines Schaufelblatts (12), das eine Schaufelblattoberflächenlinie (15) aufweist und einen Übergangsbereich (21) beinhaltet, der die Schaufelblattoberflächenlinie (15) mit einer Strömungspfadoberflächenlinie (14) mit einer 2D-Ausrundungskurve (A) verbindet;
Erzeugen eine Vielzahl von Strömungspfad-Versatzlinien (26, 26-1...26-5) auf der 2D-Abbildung an vorbestimmten Strömungspfad-Versatzwerten, wobei jede Strömungspfad-Versatzlinie (26, 26-1...26-5) von der Vielzahl von Strömungspfad-Versatzlinien (26, 26-1...26-5) in dem Übergangsbereich (21) grafisch eine Strömungspfad-Versatzoberfläche von einer Vielzahl von Strömungspfad-Versatzoberflächen darstellt;
Bestimmen eines Schnittpunkts zwischen der 2D-Ausrundungskurve (A) und jeder Strömungspfad-Versatzlinie (26, 26-1...26-5) ;
Berechnen einer Distanz zwischen der Schaufelblattoberflächenlinie (15) und jedem Schnittpunkt, um eine Vielzahl von Schaufelblatt-Versatzwerten (B) zu erzeugen;
Erzeugen einer Vielzahl von Schaufelblatt-Versatzoberflächen auf dem Computermodell des Schaufelblatts, die gemäß jedem Schaufelblatt-Versatzwert (B) von der Vielzahl von Schaufelblatt-Versatzwerten (B) erzeugt werden;
Erzeugen der Vielzahl von Strömungspfad-Versatzoberflächen auf dem Computermodell des Schaufelblatts, die gemäß jedem Strömungspfad-Versatzwert erzeugt werden; und
Erzeugen einer Vielzahl von 3D-Ausrundungsstromlinienkurven (27, 27-1...27-5), um die aerodynamisch geformte Ausrundung (22) auf dem erzeugten Computermodell des Schaufelblatts (12) zu definieren, wobei jede 3D-Ausrundungsstromlinienkurve (27, 27-1...27-5) eine Schnittfläche zwischen einer Schaufelblatt-Versatzoberfläche von der Vielzahl von Schaufelblatt-Versatzoberflächen und einer Strömungspfad-Versatzoberfläche von der Vielzahl von Strömungspfad-Versatzoberflächen umfasst, wobei das Erzeugen der Vielzahl von 3D-Ausrundungsstromlinienkurven (27, 27-1...27-5) ein Replizieren mindestens einer Biegung des Schaufelblatts (12) in die aerodynamisch geformte Ausrundung (22) umfasst, wobei die mindestens eine Biegung eine Veränderung der Krümmung, eine Veränderung der Drehung, eine Vorderkantenform oder einen Vorderkantenwinkel, eine Hinterkantenform oder einen Hinterkantenwinkel oder eine Kombination davon umfasst;
Ausgeben des Computermodells des Schaufelblatts (12), die aerodynamisch geformte Ausrundung (22) beinhaltend.

2. Verfahren nach Anspruch 1, wobei das Schaufelblatt (12) eine Vorderkante, eine Hinterkante und gegenüberliegende konvexe und konkave Seiten aufweist und das Erzeugen einer Vielzahl von 3D-Ausrundungsstromlinienkurven (27, 27-1...27-5) ein Erzeugen jeder 3D-Stromlinienkurve (27, 27-1...27-5) von der Vielzahl von 3D-Ausrundungsstromlinienkurven (27, 27-1...27-5) um den Übergangsbereich (21) des Schaufelblatts (12) herum umfasst, um sich um die Vorderkante, die Hinterkante und die konkaven und konvexen Seiten des Schaufelblatts (12) zu erstrecken, wobei der Schaufelblatt-Versatz entlang jeder 3D-Ausrundungsstromlinienkurve (27, 27-1...27-5) von im Wesentlichen gleicher Dicke ist, sodass die Dicke der aerodynamisch geformten Ausrundung (22) an der Vorderkante, der Hinterkante und den konkaven und konvexen Seiten des Schaufelblatts (12) von im Wesentlichen gleicher Dicke ist.

## Revendications

1. Procédé de génération d'un modèle informatique d'un profil aérodynamique (12) comprenant un filet de forme aérodynamique (22), le procédé comprenant :
l'entrée d'une image 2D d'un profil aérodynamique (12) ayant une ligne de surface de profil aérodynamique (15) et comprenant une région de transition (21) interconnectant la ligne de surface de profil aérodynamique (15) à une ligne de surface de chemin d'écoulement (14) avec une courbe de filet 2D (A) ;
la génération d'une pluralité de lignes de décalage de chemin d'écoulement (26, 26-1...26-5) sur l'image 2D à des valeurs de décalage de chemin d'écoulement prédéterminées, chaque ligne de décalage de chemin d'écoulement (26, 26-1...26-5) de la pluralité de lignes de décalage de chemin d'écoulement (26, 26-1...26-5) dans la région de transition (21) représentant graphiquement une surface de décalage de chemin d'écoulement d'une pluralité de surfaces de décalage de chemin d'écoulement ;
la détermination d'un point d'intersection entre la courbe de filet 2D (A) et chaque ligne de décalage de chemin d'écoulement (26, 26-1...26-5) ;
le calcul d'une distance entre la ligne de surface de profil aérodynamique (15) et chaque point d'intersection afin de générer une pluralité de valeurs de décalage de profil aérodynamique (B) ;
la génération d'une pluralité de surfaces de décalage de profil aérodynamique sur le modèle informatique du profil aérodynamique généré selon chaque valeur de décalage de profil aérodynamique (B) de la pluralité de valeurs de décalage de profil aérodynamique (B) ;
la génération de la pluralité de surfaces de décalage de chemin d'écoulement sur le modèle informatique du profil aérodynamique généré en fonction de chaque valeur de décalage de chemin d'écoulement ; et
la génération d'une pluralité de courbes de profilé de filet 3D (27, 27-1...27-5) pour définir le filet de forme aérodynamique (22) sur le modèle informatique du profil aérodynamique (12) étant généré, chaque courbe de profilé de filet 3D (27, 27-1...27-5) comprenant une intersection entre une surface de décalage de profil aérodynamique de la pluralité de surfaces de décalage de profil aérodynamique et une surface de décalage de chemin d'écoulement de la pluralité de surfaces de décalage de chemin d'écoulement, dans lequel la génération de la pluralité de courbes de profilé de filet 3D (27, 27-1...27-5) comprend la réplication d'au moins une flexion du profil aérodynamique (12) dans le filet de forme aérodynamique (22), dans lequel l'au moins une flexion comprend un changement de carrossage, un changement de torsion, une forme ou un angle de bord d'attaque, une forme ou un angle de bord de fuite, ou des combinaisons de ceux-ci ;
la sortie du modèle informatique du profil aérodynamique (12) comprenant le filet de forme aérodynamique (22).

2. Procédé selon la revendication 1, dans lequel le profil aérodynamique (12) a un bord d'attaque et un bord de fuite, et des côtés opposés convexe et concave, et la génération d'une pluralité de courbes de profilé de filet 3D (27, 27-1...27-5) comprend la génération de chaque courbe de profilé 3D (27, 27-1...27-5) de la pluralité de courbes de profilé de filet 3D (27, 27-1...27-5) autour de la région de transition (21) du profil aérodynamique (12) pour s'étendre autour du bord d'attaque, du bord de fuite et des côtés concave et convexe du profil aérodynamique (12), avec le profil aérodynamique décalé le long de chaque courbe de profilé de filet 3D (27, 27-1...27-5) étant d'épaisseur sensiblement égale de sorte que l'épaisseur du filet de forme aérodynamique (22) au niveau du bord d'attaque, du bord de fuite et des côtés concave et convexe du profil aérodynamique (12) est d'épaisseur sensiblement égale.
